# EUROPÄISCHE PATENTANMELDUNG

(11) **EP 1 320 287 A1**
(43) Veröffentlichungstag der Anmeldung: **18.06.2003**
(21) Anmeldenummer: 03006007.3
(22) Anmeldetag: 04.01.2001
(51) Int. Cl.: H05K 3/10, H05K 3/00

(54) **Elektrisches Verbindungselement und Halbzeug**

(30) Priorität: 04.01.2000 DE 10000090
(62) Teilanmeldung aus: 01900010.8
(71) Anmelder: Elmicron AG, 6072 Sachseln (CH)
(72) Erfinder: Walz, Silke, 6060 Sarnen (CH); Steiert, Phillippe, 6404 Greppen (CH); Schmidt, Walter, 8332 Russikon (CH)
(74) Vertreter: Frei, Alexandra Sarah

(57) **Zusammenfassung**

Das Verfahren zum Herstellen eines elektrischen Verbindungselements zeichnet sich im Wesentlichen dadurch aus, dass in einem Prägeschritt mit einem Prägewerkzeug (11) ein plastisch verformbares Substrat (1a) dergestalt verformt wird, dass dort Vertiefungen entstehen (1b), wo Leiterbahnen und bspw. auch Durchgangslöcher oder Kontaktierungsflächen entstehen sollen. Anschliessend erfolgt eine Beschichtung des Substrats mit einer dünnen Leiterschicht (1d). In einem nächsten Schritt wird auf dem Substrat so lange galvanisch Leitermaterial (103) abgeschieden, bis die Vertiefungen mit Leitermaterial aufgefüllt sind (1e). Daraufhin wird Leitermaterial (103) durch einen Abtragprozess, bspw. einem Ätzprozess so lange abgetragen, bis diejenigen Stellen des Substrats frei von einer Metallbeschichtung sind, die keine leitende Oberfläche aufweisen sollen (1f).

## Beschreibung

Die Erfindung bezieht sich auf das Gebiet der Herstellung von elektrischen Verbindungselementen, bspw. Leiterplatten, High-Density-Interconnects, Ball-Grid-Array- (BGA-) Substraten, Chip Scale Packages (CSP), Multi-Chip-Module-(MCM-) Substrate, etc..

Die ständig fortschreitende Miniaturisierung im Bereich der Mikroelektronik wirkt sich auch auf die Herstellung von elektrischen Verbindungselementen, insbesondere von Leiterplatten, Interconnects etc. aus. Es besteht in vielen Anwendungsbereichen die Notwendigkeit, die konventionelle Herstellung von Leiterplatten durch neue Methoden schrittweise zu ersetzen. Die konventionelle Herstellung von Leiterstrukturen beruht auf photochemischen Verfahren und dem mechanischen Bohren von Durchgangslöchern. Neuere Ansätze beinhalten das Bohren von kleinsten Löchern mittels Lasern oder durch Plasmaätzen bzw. durch mechanisches Eindrücken von Perforationswerkzeugen in Leiterplattenmaterial (Mikroperforation, vgl. dazu die internationale Offenlegungsschrift WO 00/13062).

Während das Bohren von Mikrolöchern zunehmend mit neuen, den aktuellen Anforderungen angemessenen Methoden durchgeführt wird, wird die Strukturierung von Leiterzügen nach wie vor mit der an sich bewährten Methode der Photostrukturierung durchgeführt. Diese involviert aber eine Vielzahl von Fertigungsschritten, darunter das Belichten, Entwickeln und Strippen von Photoresist. Sie ist damit relativ aufwändig und beinhaltet auch unter Umweltschutzaspekten Nachteile.

In der US-Patentschrift 6 035 527 wird ein Ansatz vorgestellt, mit welchem eine Nutzbarmachung einer moderneren Lochformungstechnik auch für die Herstellung von Leiterbahnen vorgestellt wird. Der Ansatz beruht darauf, dass im Substrat Vertiefungen im Wesentlichen rechteckigem Querschnitt durch Laser-Ablation hergestellt werden. Anschliessend wird das ganze Substrat mit einer dünnen leitenden Schicht versehen, bspw. durch ein Chemical-Vapour-Deposition (CVD)-Verfahren. Daraufhin wird diese in einem selektiven Verfahren überall dort entfernt, wo keine Leiterbahn entstehen soll, d.h. überall ausser in Vertiefungen. Dieses selektive Entfernen kann bspw. ebenfalls durch Laser-Ablation bewerkstelligt werden. Anschliessend wird Metall chemisch abgeschieden, wobei die nicht entfernten Bereiche der leitenden Schicht als Keimlage ("Seed Layer") dienen. Durch dieses Verfahren wird die Anzahl der nasschemischen Prozesse reduziert. Es werden aber mehrere sequenzielle Laser-Ablationsschritte durchgeführt, weshalb das Verfahren für komplexe Leiterplatten zu langsam ist. Gemäss einer Variante wird wenigstens der zweite Laser-Ablationsschritt eliminiert. Dies geschieht, indem nach dem Aufbringen der dünnen, leitenden Schicht in an sich in Fachkreisen schon lange bekannter Art das ganze Substrat galvanisch oder durch chemisches Abscheiden so lange mit Metall beschichtet wird, bis eine ebene Oberfläche entsteht. Die dadurch entstandene Schicht wird anschliessend abgeätzt, bis nur noch Material in den Leiterbahnen vorhanden ist. Dieses Verfahren hat folgende Nachteile: Der sequentiell arbeitende Laser-Abtrag, die bei konventionell ausgeführten chemischen Verfahrensschritten grossen abzuätzenden Schichtdicken und das ungünstige erreichbare Verhältnis zwischen Tiefe und Breite (Aspektverhältnis) der Leiterbahnen. Ausserdem hat sich gezeigt, dass es beim Abätzen der Metallschicht praktisch nicht zu vermeiden ist, dass auch die sehr seichten Vertiefungen ausgeätzt werden, wodurch Unterbrüche entstehen. Die Herstellung von tiefen Gräben durch Laser-Ablation ist aber schon aus wirtschaftlichen Gründen nicht sinnvoll. Ausserdem sind schmale, tiefe Gräben aufgrund des vorstehend angedeuteten ungünstigen erreichbaren Aspektverhältnisses diesem Verfahren nicht zugänglich.

Im Unterschied zu konventionellen Verfahren ist in der US-Patentschrift 6 005 198 ein Verfahren zur Herstellung von Leiterplatten beschrieben, welches unter anderem das simultane Eindrücken von U-förmigen Rinnen und von tassenförmigen Vertiefungen durch ein Prägewerkzeug in ein isolierendes und vorzugsweise duroplastisches Substrat vorsieht. Zur Bildung von Sacklöchern zur elektrischen Verbindung zweier Leiterlagen aus den tassenförmigen Vertiefungen muss anschliessend noch Material chemisch oder mechanisch entfernt werden. Daraufhin werden die Rinnen und die Vertiefungen metallisiert. Dies geschieht bspw., indem eine leitfähige Paste mit einer Gummiwalze in die Vertiefungen gepresst wird. Alternativ dazu kann auch das ganze Substrat beschichtet und anschliessend isolierendes Material (Ätzresist) mit einer Gummiwalze in die Vertiefungen eingebracht werden. In einem darauf folgenden Ätzprozess wird aufgrund des Ätzresists die in den Vertiefungen vorhandene Metallschicht geschützt. Durch dieses Verfahren werden einige Verarbeitungsschritte eingespart. Das Verfahren bedingt aber nach wie vor mehrere nasschemische Prozesse. Aufgrund der für die Funktionsfähigkeit des Verfahrens notwendigen relativ breiten U-Form der Vertiefungen sind ausserdem der Miniaturisierung Grenzen gesetzt. Ausserdem bestehen die Leiterbahnen konstruktionsbedingt entweder aus relativ wenig leitfähiger, aushärtbarer Paste ("conductive ink") oder sie sind vergleichsweise dünn. Aus diesem Grund sind auch der erreichbaren Zuverlässigkeit und der durch die Leiterbahnen übertragbaren Leistung Grenzen gesetzt. Das Verfahren hat sich in der Praxis als wenig tauglich erwiesen, da das Eindrücken der Leiterpasten bzw. des Ätzresists immer mit Verschmierungen dieser Materialien auf der restlichen Oberfläche einhergeht. Die Oberfläche muss aber absolut frei und sauber sein, was dazu führt, dass diese nach dem Beschichtungsprozess und dem Aushärten mechanisch abgeschliffen werden muss.

Der Erfindung stellt sich die Aufgabe, ein neues Verfahren zur Herstellung von Leiterplatten zur Verfügung zu stellen. Um im Vergleich zum Stand der Technik noch höheren Anforderungen in Bezug auf Verfahrenseffizienz, Kosten und Miniaturiserung gerecht zu werden, sollten folgende Punkte erfüllt sein:
- Alle Verfahrensschritte müssen möglichst parallel ablaufen. Sequenzielle Verfahrensschritte verkomplizieren und verteuern die Herstellung.
- Die Anzahl der nasschemischen Schritte muss aus verfahrensökonomischen und auch aus ökologischen Beweggründen möglichst klein gehalten werden.
- Auch die notwendige Anzahl der Verfahrensschritte insgesamt sollte im Vergleich zu bestehenden Verfahren reduziert werden.
- Das Verfahren soll ermöglichen, dass die Strukturen wie Leiterbahnen und Durchgangslöcher möglichst kleine laterale Abmessungen haben. Dabei darf aber im Vergleich zum Stand der Technik die Zuverlässigkeit und die Leistungsfähigkeit nicht kleiner werden. Bei Leiterbahnen ergibt sich daher die Forderung, dass sie im Vergleich zu bestehenden Systemen weniger flache Querschnitte, d.h. einen hinreichend grossen Querschnitt aufweisen sollten.
- Schliesslich sollte es aufgrund der immer feineren und komplexeren erreichbaren Strukturen vermieden werden, dass das Produkt häufig relativ zu einem Werkzeug in einer Genauigkeit positioniert werden muss, welche der Feinheit der Strukturen Rechnung trägt.

Ein Verfahren mit diesen Eigenschaften wird von der Erfindung zur Verfügung gestellt. In den Patentansprüchen sind ein mit einem solchen Verfahren hergestelltes Verbindungselement oder Halbzeug, ein Prägewerkzeug mit den entsprechenden Strukturen sowie eine Prägevorrichtung definiert.

Das Verfahren zeichnet sich im Wesentlichen dadurch aus, dass in einem Prägeschritt mit einem Prägewerkzeug ein plastisch verformbares Substrat dergestalt verformt wird, dass dort Vertiefungen entstehen, wo Leiterbahnen und bspw. auch Durchgangslöcher oder Kontaktierungsflächen entstehen sollen. Anschliessend erfolgt eine Beschichtung des Substrats mit einer dünnen Leiterschicht. In einem nächsten Schritt wird das ganze Substrat galvanisch mit Leitermaterial überwachsen, bis die Vertiefungen mit Leitermaterial aufgefüllt sind. Daraufhin wird Leitermaterial durch einen Abtragprozess so lange abgetragen, bis diejenigen Stellen des Substrats frei von einer Metallbeschichtung sind, die keine leitende Oberfläche aufweisen sollen.

Dabei weisen mindestens einige Strukturen eine Querschnittsfläche auf, in welcher das Aspektverhältnis (das Verhältnis von Tiefe zu Breite) mindestens 1:2, bspw. mindestens 1:1 und vorzugsweise zwischen 1:2 und 5:1 beträgt. Die Strukturen sind beidseitig auf dem Substrat aufgebracht. Die Durchgangslöcher sind ebenfalls mechanisch (durch Prägen) beigebracht.

Gemäss einer bevorzugten Ausführungsform erfolgt nach dem Prägeschritt eine Plasma-Nachbehandlung. Durch diese können bspw. Durchgangslöcher an den dafür vorgesehenen Stellen von Restschichten befreit werden.

Die erfindungsgemässe Leiterplattenherstellung ist verblüffend einfach. Es sind ein einziger Verformungsschritt, ein Beschichtungsschritt und zwei nasschemische Schritte notwendig. Sowohl der Beschichtungsschritt als auch beide nasschemischen Verfahrensschritte werden flächendeckend am Substrat als Ganzem durchgeführt und bedingen daher - wie z.B. beim Laser-Ablationsverfahren kein laterales Positionieren des Substrat im Bezug auf ein Werkzeug. Sie sind daher sehr einfach durchzuführen. Auch der Prägeschritt bedingt - nach Einrichten des Prägewerkzeugs - keinerlei Genauigkeit bei der Handhabung, auch für die Herstellung feinster Strukturen. Zusätzlich ist die Optimierung der Leiterbahn-Querschnitte mit der Erfindung in höchst einfacher Weise lösbar. Die Leiterbahnen können bspw. einen im Wesentlichen rechteckigen Querschnitt aufweisen, welcher dabei aber ein im Vergleich zum Stand der Technik wesentlich günstigeres Aspektverhältnis besitzt.

Die Erfindung beruht auf einer Reihe von neuen und überraschenden Erkenntnissen.

Eine erste Erkenntnis ist, dass Thermoplaste und auch Duroplaste existieren, welche sich in hervorragender Weise für die Prägung von Leiterplatten-Substraten eignen. Beispiele für solche Substrate sind Flüssigkristall-Polymere (Liquid Crystal Polymers, LCPs). Weitere Möglichkeiten sind Polysulfone, Epoxidharze, die über der Glasumwandlungstemperatur verformbar sind, gewisse Polyester (PEEK), Polycarbonate etc.

Eine weitere Erkenntnis ist diejenige, dass sich Prägewerkzeuge mit fast beliebigen Strukturierungen herstellen lassen. Diese Erkenntnis ist zum Teil schon beschrieben in der internationalen Offenlegungsschrift WO 00/13062, deren Inhalt hier mit einbezogen wird.

Zusätzlich besteht auch die sehr überraschende Erkenntnis, dass das galvanische Auffüllen von im Wesentlichen kanalförmigen, d.h. langgezogenen Vertiefungen möglich ist, welche ein Aspektverhältnis von mehr als 1:2 und bspw. 1:1 oder grösser aufweisen. Auch das Verhältnis zwischen Strukturtiefe und insgesamt beim Galvanisieren abgeschiedenem Material kann überraschend günstig sein. Das Galvanisieren ist auch möglich, ohne dass sog. "Lunker" entstehen, d.h. unvollständige Auffüllungen der Vertiefungen. Diese ergaben sich gemäss dem Stand der Technik automatisch bei herkömmlichen galvanischen Verfahren, da sich in diesen aufgrund der elektrischen Feldverteilung das aufgalvanisierte Material bevorzugt and der Oberfläche und an Kanten anlagert und nicht in den Vertiefungen. Wenn gemäss dem Stand der Technik Vertiefungen galvanisch aufgefüllt wurden, soweit das überhaupt möglich war, wurde, das sog. "reverse-puls-plating"-Verfahren verwendet. Gemäss diesem Verfahren wird der Strom mehrmals umgepolt, was dazu führt, dass Material abwechselnd auf das Substrat aufgeschieden und wieder abgetragen wird. Damit kann im optimalen Fall eine "Lunker"-Bildung vermieden werden, der apparative Aufwand, die einzusetzende Energie und die verlängerte Herstellungszeit sind aber grosse Nachteile.

Im Folgenden werden noch Ausführungsbeispiele der Erfindung anhand von Zeichnungen genauer beschrieben. In den Zeichnungen zeigen:
- die Figuren 1 bis 5 die Abfolge von Verfahrensschritten einer Ausführungsform des erfindungsgemässen Verfahrens anhand sehr schematischer Zeichnungen von entsprechenden Vorrichtungen,
- die Figur 1a schematisch einen Schnitt durch einen Abschnitt eines Prägestempels,
- die Figur 6 schematisch ein Beispiel einer Anlage für die Herstellung von Leiterplatten mit dem erfindungsgemässen Verfahren,
- die Figuren 7a und 7b Beispiele für Galvanisiervorgänge gemäss dem Stand der Technik,
- Figuren 8a und 8b Beispiele für erfindungsgemäss galvanisch aufgefüllte Leiterbahnen im Querschnitt senkrecht zur Substratoberfläche
- Figur 9 schematisch eine Draufsicht auf einen entlang einer horizontalen Ebene geschnittenen Behälter zur Ausführung des galvanischen Prozessschrittes als Batch-Prozess,
- Figuren 9a und 9b Details zu Figur 9,
- Figur 9c einen vertikalen Schnitt durch die Anordnung der Figur 9,
- Figur 10 sehr schematisch ein Beispiel für eine Anordnung zur Durchführung des galvanischen Prozessschrittes als kontinuierlicher Prozess,
- Figur 11 ein Schema für den Elektrolytkreislauf gemäss einer speziellen Variante,
- Figuren 12a, 12b und 12c Schnitte durch einen Bereich einer Leiterplatte während verschiedenen Stadien im Herstellungsprozess,
- Figuren 13a, 13b und 13c Schnitte durch einen Bereich einer Ausführungsform des erfindungsgemässen elektrischen Verbindungselements während verschiedenen Stadien der Herstellung,
- Figuren 14a, 14b und 14c Schnitte durch einen Bereich einer weiteren Ausführungsform der erfindungsgemässen elektrischen Verbindungselements während verschiedenen Stadien der Herstellung.

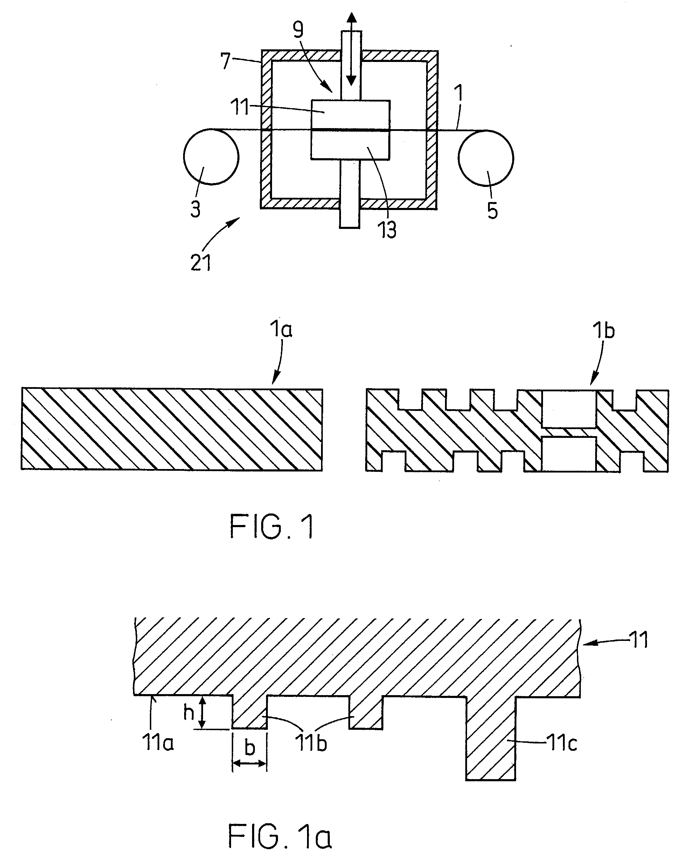

In der **Figur 1** ist schematisch ein Substrat 1a dargestellt. Dieses ist im hier dargestellten Beispiel eine Liquid-Chrystal-Polymer (Flüssigkristallpolymer, LCP)-Folie. Das Substrat ist auch als zur Bildung einer Vielzahl von Substraten für elektrische Verbindungselemente, nämlich für Leiterplatten gedachte Endlosfolie 1 gezeichnet.

Flüssigkristallpolymere sind polymere Kunststoffe, in denen die einzelnen Moleküle in einer partiell geordneten Ausrichtung zueinander "eingefroren" sind. Flüssigkristallpolymere sind an sich bekannt. Sie sind Thermoplaste mit einer Reihe von Eigenschaften, die sie in hervorragender Weise für die Verwendung als Leiterplattensubstrate eignen lassen. So sind sie bspw. dimensionsstabil, selbstlöschend und nehmen praktisch kein Wasser auf. Der Wert für die Dielektrizitätskonstante εᵣ beträgt ungefähr 2,9, was für hochfrequente Schaltungen sehr vorteilhaft ist.

Das erfindungsgemässe Verfahren kann selbstverständlich auch mit anderen Substraten als mit LCP-Folien durchgeführt werden. Insbesondere sind auch Substrate denkbar, welche dicker sind als Folien gemäss deren gängiger Definition.

Auch andere plastisch verformbare Materialien als LCPs sind möglich, wobei hier auf die Fachliteratur verwiesen sei.

In der Figur 1 dargestellt ist eine Vorrichtung 21 zum Prägen von elektrischen Verbindungselementen. Sie weist eine Abgaberolle 3 und eine Aufnahmerolle 5 auf, die beide ausserhalb einer Prägekammer 7 angeordnet sind. Ins Innere der Prägekammer ragt ein Prägewerkzeug 9, bspw. ein Mikro-Prägewerkzeug, welches einen oberen 11 und einen unteren Prägestempel 13 aufweist. Die Substratfolie 1 wird von der Abgaberolle 3, der Aufnahmerolle 5 und von Öffnungen in Wänden der Prägekammer so geführt, dass sie sich durch die Prägekammer 7 erstreckt. Alternativ dazu könnten die Abgabe- und die Aufnahmerolle auch im Innern der Prägekammer angeordnet sein. Ein Prägeschritt sieht das gegeneinander Pressen der beiden Prägestempel 11, 13 vor. Dabei werden dem Substrat beidseitig gleichzeitig Vertiefungen beigebracht. Mindestens einige dieser Vertiefungen sind im Wesentlichen kanalförmig. Anschliessend an das Prägen wird die Substratfolie auf die Aufnahmerolle 5 aufgewickelt. Für den Prägeschritt wird das Substrat je nach Substratmaterial auf eine Temperatur aufgewärmt, bei der es plastisch verformbar ist. Das durch den Prägeschritt entstandene bearbeitete Substrat 1b ist in der Figur ebenfalls dargestellt.

In der **Figur 1a** ist noch ein Detail des oberen Prägestempels 11 dargestellt. Der Prägestempel ist bspw. im LIGA-Verfahren hergestellt und besitzt eine Oberfläche 11a und über diese heraus ragende Erhebungen 11b, 11c. Dabei kann unterschieden werden zwischen kammartigen bzw. kammförmigen Erhebungen 11b, welche in einer (in der Zeichnung zur Bildebene senkrechten) Richtung ausgedehnt sind und der Bildung von kanalförmigen Vertiefungen für Leiterbahnen dienen, und dornartigen Erhebungen 11c zur Bildung von Durchgangslöchern. Mindestens einige der kammartigen Erhebungen 11b weisen eine zur Oberfläche 11a senkrechten Querschnitt auf, in dem die Breite b höchstens doppelt so gross ist wie die Höhe h.

Im hier gezeichneten Beispiel ist der Prägestempel metallisch, er kann aber auch aus einem beliebigen anderen Material gefertigt sein, welches härter ist als bspw. Kupfer.

Im hier beschriebenen Beispiel sind zwei Prägestempel gezeichnet, zwischen denen das Substrat beim Prägeschritt zusammengepresst wird. Es ist aber auch denkbar, dass nur ein Prägestempel vorhanden ist, welcher gegen das an einer harten Oberfläche anliegende Substrat gepresst wird. In diesem Fall werden dem Substrat natürlich nur auf einer Seite Vertiefungen beigebracht.

Es ist auch möglich, das der Prägeschritt mehrere verschiedene Prägevorgänge umfasst. So kann bspw. ein mit einem Grob-Prägewerkzeug beigebrachten Grob-Prägeschritt und anschliessend mit einem Fein-Prägewerkzeug ein Fein-Prägeschritt erfolgen.

Der Prägeschritt kann alternativ zu gegeneinander pressen von zwei Prägestempeln auch durch das Prägen über rotierende Rollen ("Rollenprägung") bewerkstelligt werden.

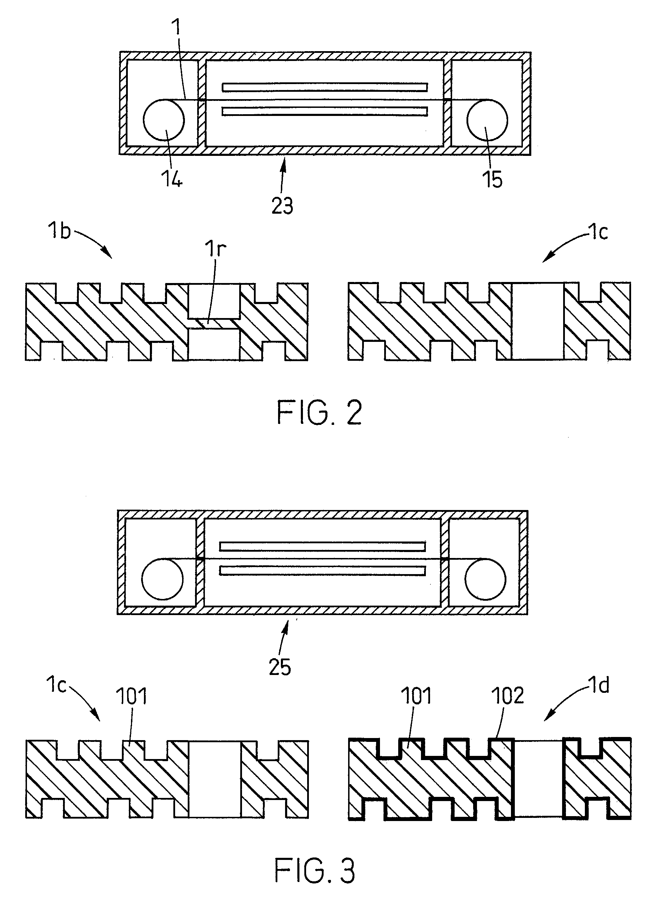

Der in der **Figur 2** dargestellte Nachreinigungs- oder Nachbehandlungsschritt erfolgt bspw. mit Plasma-Ätzen. Alternativ dazu wäre auch ein nasschemischer Prozess denkbar. Der Plasma-Ätzschritt erfolgt in einer an sich bekannten und bereits mehrfach in Publikationen beschriebenen Art in einer Plasma-Ätzvorrichtung 23. Dabei wird das Substrat 1 bspw. ebenfalls zwischen einer Abgabe- 13 und einer Aufnahmerolle 15 gespannt. Der Nachbehandlungsschritt erfüllt den Zweck, noch verbliebene und durch das Prägewerkzeug nicht entfernte Materialreste 1r abzutragen. Solche Materialreste 1r verbleiben bspw. am geprägten Substrat 1b an Orten, wo Durchgangslöcher entstehen sollen. Das nachbehandelte Substrat 1c ist in der Figur 2 ebenfalls schematisch dargestellt.

In einem weiteren Schritt wird gemäss **Figur 3** eine Beschichtung mit einer dünnen Leiterschicht aufgebracht. Dies kann beispielsweise in einer Vakuumkammer mittels Sputtern geschehen. Auch andere Methoden wie Chemical Vapour Deposition (CVD), thermisches Aufdampfen, anodisches Aufdampfen oder weitere chemische oder physikalische Methoden sind denkbar. Als Beschichtungsmaterial wird vorzugsweise Kupfer verwendet, aber auch andere Leitermaterialien wie Silber etc. sind möglich. Bei bestimmten Polymermaterialien kann direkt Kupfer aufgebracht werden, ohne dass Probleme mit der Haftfestigkeit auftreten. In anderen Fällen müssen zuerst sogenannte Haftschichten aus Chrom, Titan oder Wolfram abgeschieden werden. In einem zweiten Schritt wird üblicherweise Kupfer aufgebracht. In einem solchen Fall setzt sich die dünne Leiterschicht also aus zwei oder eventuell auch mehr metallischen Schichten zusammen.

Auch der Beschichtungsschritt erfolgt beispielsweise in einer Vorrichtung 25 mit einer Abgabe- und einer Aufnahmerolle, zwischen welchen Rollen die Substratfolie gespannt wird. Der Beschichtungsschritt hat zur Aufgabe, das Substrat für die nachfolgende galvanische Bearbeitung leitfähig zu machen und ein Interface zwischen dem isolierenden Substratmaterial und dem aufgalvanisierten Leitermaterial zu bilden. Die Beschichtungsvorrichtung 25 ist in der Figur 3 wie die Nachreinigungsvorrichtung der Figur 2 und nur sehr schematisch dargestellt. Der Fachmann wird ohne Weiteres erkennen, welche Elemente eine Beschichtungsvorrichtung aufweisen muss (bspw. Mittel zur Erzeugung und Erhaltung eines Vakuums, bspw. eine Ionenquelle, mindestens ein Target und ggf. Ionenumlenkmittel, wenn die Beschichtungsvorrichtung eine Sputtervorrichtung ist). Auch in der Figur 3 ist das Substrat vor dem Beschichtungsschritt 1c und - nach dem Beschichtungsschritt - als Substratschicht (Dielektrikum) 101 mit einer Beschichtung 102 dargestellt.

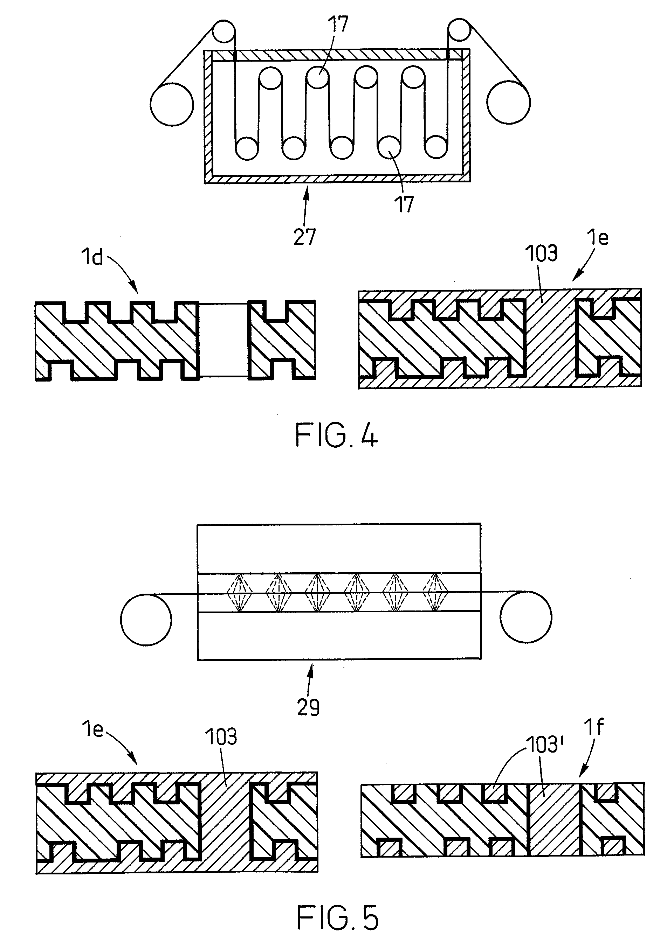

Nachdem die Beschichtung erfolgt ist, wird auf dem ganzen Substrat Leitermaterial abgeschieden, bis die Vertiefungen aufgefüllt sind, wie das in der **Figur 4** dargestellt ist. Dies erfolgt galvanisch in einer Elektrolytzelle. Dabei wird für den Plattierungsprozess bspw. kein *"Reverse Pulse Plating"* verwendet, d.h. die Polung wird beim Galvanisierungsprozess nicht oder bspw. höchstens zweimal umgekehrt. Als Materialien kommen Kupfer, aber prinzipiell auch andere Leitermaterialen in Frage, bspw. Silber. Auch die Vorrichtung 27 für diesen Bearbeitungsschritt weist bspw. Rollen 17 auf, zwischen denen das Zwischenprodukt aufgespannt wird. Die hier gezeichnete Anordnung ist sehr schematisch, auf den Elektroplattierschritt wird nachfolgend noch näher eingegangen. Das Produkt vor dem Bearbeitungsschritt ist mit 1d, nach dem Bearbeitungsschritt mit 1e gekennzeichnet. Nach dem Bearbeitungsschritt weist die Substratschicht eine die Vertiefungen füllende und darüber hinaus auch das ganze Substrat flächig bedeckende Plattierung 103 auf.

Daher wird in einem weiteren Schritt gemäss **Figur 5** die Plattierung so lange abgetragen, bis das Leitermaterial 103' nur noch and den Stellen vorhanden ist, an denen es vorgesehen ist, also in Vertiefungen für Leiterbahnen, Durchgangslöchern und an Kontaktierungsstellen. Das Abtragen erfolgt bspw. nasschemisch durch Ätzen. Das Zurückätzen erfolgt in einer Zurückätzvorrichtung 29 in an sich bekannter Art, bspw. im Chemikalienbad oder, wie dargestellt, durch Besprühen mit einer Ätzlösung. Alternativ zum Ätzen sind aber auch andere Abtragmethoden verwendbar, bspw. mechanische Abtragmethoden (bpw. Feinschleifen-"lappen") oder weitere chemische oder physikalische Abtragmethoden.

Für alle vorstehend beschriebenen Arbeitsschritte sind auch andere Methoden zum Halten des Substrats denkbar als die in den Figuren dargestellte "reel-to-reel" Methode des Spannens des als Folie ausgebildeten Substrates zwischen zwei Rollen. Alternativen sind bspw. eine Aufhängung oder Halterung eines formsteifen Substrats lediglich am Rand, das Aufspannen bzw. Aufklebens des Substrates auf eine Platte, das Einspannen des Substrates in einen Rahmen, etc.

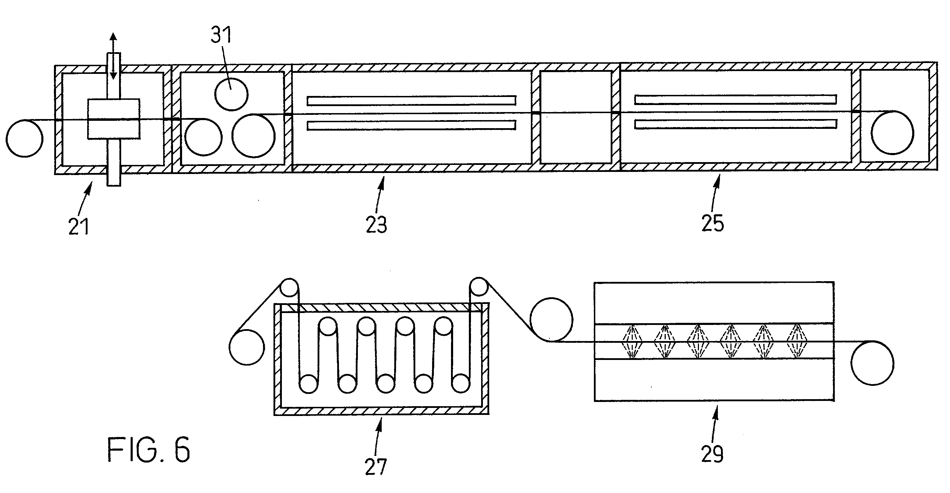

Die vorstehend beschriebenen Verfahrensschritte werden vorzugsweise in einer Anlage zur automatisierten Herstellung von Leiterplatten vorgenommen. Wie das in der **Figur 6** schematisch dargestellt ist, besteht eine solche Anlage aus einem Vakuumabschnitt und einem Abschnitt zur Durchführung der nasschemischen Schritte. Der Vakuumabschnitt umfasst Vorrichtungen zur Durchführung des Prägeschrittes 21, zur Nachreinigung mittels Plasmaablation 23, und zur Beschichtung 25. Der Vakuumabschnitt weist vorzugsweise mehrere Kammern auf. Der Abschnitt zur Durchführung der nasschemischen Schritte weist eine Elektroplattiervorrichtung 27 und eine Ätzvorrichtung 29 auf. Wesentliche Merkmale der einzelnen Vorrichtungen wurden schon vorstehend anhand der Beschreibung der Verfahrensschritte erläutert. Die Vorrichtungen werden daher hier nicht noch einmal beschrieben.

Alternativ zur Anordnung der Figur 6 kann die Prägevorrichtung auch ausserhalb des Vakuums angebracht sein, und die Prägung also in einer sauerstoffhaltigen Atmosphäre oder bspw. unter Schutzgas durchgeführt werden.

Die Vorrichtung zur Durchführung des Prägeschrittes 21 kann bspw. im Unterschied zu der anhand von Figur 1 bereits erläuterten und auch in der Figur 6 dargestellten Vorrichtung auch mehrere Prägestempel umfassen. In diesem Fall findet eine parallele Prägung an mehreren Substraten statt. Weiter können zwischen den einzelnen Vorrichtungen zusätzlich zu den Abgabe- und Aufnahmerollen noch Speicherrollen 31 ("Pufferrollen") vorhanden sein. Diese dienen bspw. als Speicher und Puffer und sind insbesondere auch zwischen Vorrichtungen mit unterschiedlichen Taktzeiten vorzusehen.

Im Folgenden soll noch näher auf den Schritt des Aufgalvanisierens des Leitermaterials eingegangen werden. Bislang wurden zum galvanischen Auffüllen mit Leitermaterial nur flache Strukturen in Betracht gezogen. Dies ist unter anderem darin begründet, dass sich beim Galvanisieren das Material naturgemäss dort anlagert, wo die elektrischen Felder gross sind, also bevorzugt an Ecken und Kanten. Das hier zu beschreibende Ausführungsbeispiel der Erfindung beruht aber darauf, dass Leiterbahnen vorgeformt und aufgefüllt werden, die einen Querschnitt besitzen, bei welchem das Aspektverhältnis als das Verhältnis von Tiefe zu Breite mindestens 1:2 und beispielsweise annähernd 1:1 oder mehr beträgt.

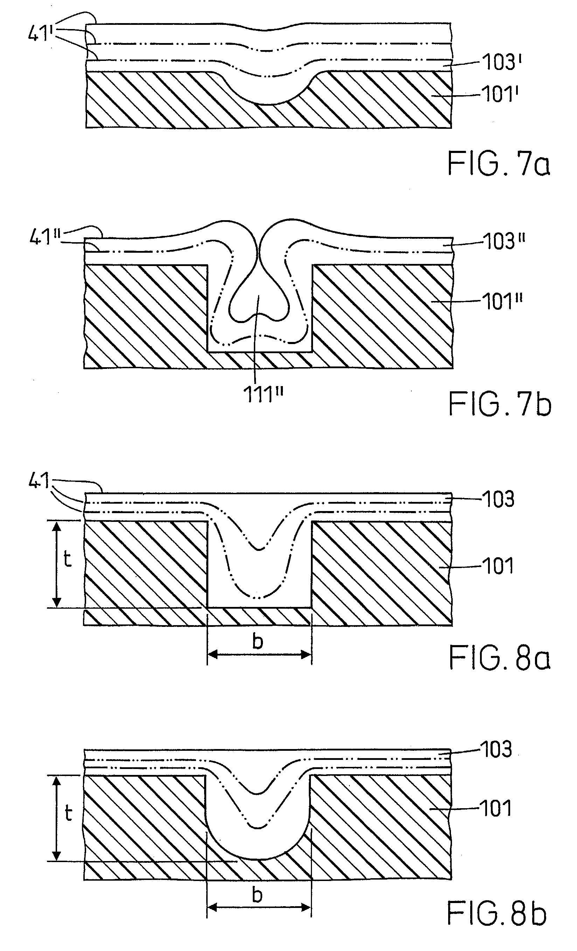

In den **Figuren 7a und 7b** ist aufgezeigt, wie gemäss dem Stand der Technik aufgalvanisiert wird. In diesen wie in den folgenden Figuren wurde aus Gründen der Übersichtlichkeit die Schraffur für die aufgalvanisierten metallischen Schichten weggelassen. In der Figur 7a ist eine typische Substratform 101' dargestellt, welche eine dünne Beschichtung aufweist, und auf welche eine Leiterschicht 103' aufgalvanisiert wurde. Die dargestellten Linien 41' zeigen den Verlauf der Oberfläche des Leitermaterials bei verschiedenen Mengen aufgetragenen Materials. Auch bei relativ grossen Schichtdicken sind Vertiefungen im Substrat auf der Oberfläche noch sichtbar. In der **Figur 7b** ist schematisch die sog. "Lunker"-Bildung dargestellt. Auch hier zeigen die Linien 41" den Verlauf der Oberfläche bei verschiedenen Mengen aufgetragenen Materials. Da sich das Leitermaterial 103" beim Galvanisieren auf das beschichtete Substrat 101" an Ecken bevorzugt und in Vertiefungen kaum anlagert, bildet sich eine Art Hohlraum ("Lunker") 111', wenn das Verhältnis zwischen Breite und Tiefe der aufzufüllenden Vertiefung klein wird.

Daher wurden Vertiefungen, bei denen das Aspektverhältnis mehr als 1:3, 1:2 oder gar 2:3 oder 1:1 oder mehr beträgt, bisher nicht für das galvanische Auffüllen in Betracht gezogen. Die Erfindung ermöglicht, dass auch dieser Bereich zugänglich wird.

In den **Figuren 8a und 8b** sind Vertiefungen dargestellt, die gemäss dem Ausführungsbeispiel der Erfindung aufgefüllt werden. Die Linien 41 stellen dabei die Oberfläche der Leiterschicht 103 während verschiedenen Stadien des Galvanisierens dar. Wie aus der Figur deutlich hervorgeht, wird sehr rasch eine flache Oberfläche erreicht. Die gestrichelte Linie in den Figuren stellen die Oberflächenebene des Substrats dar. Die Grössen *b* und *t* stehen für Breite respektive Tiefe der Vertiefung. Neben den in den Figuren dargestellten, näherungsweise rechteckigen bzw. U-förmigen Querschnitten sind auch beliebige andere, mit einem Prägestempel beibringbare Querschnitte für die Vertiefungen denkbar.

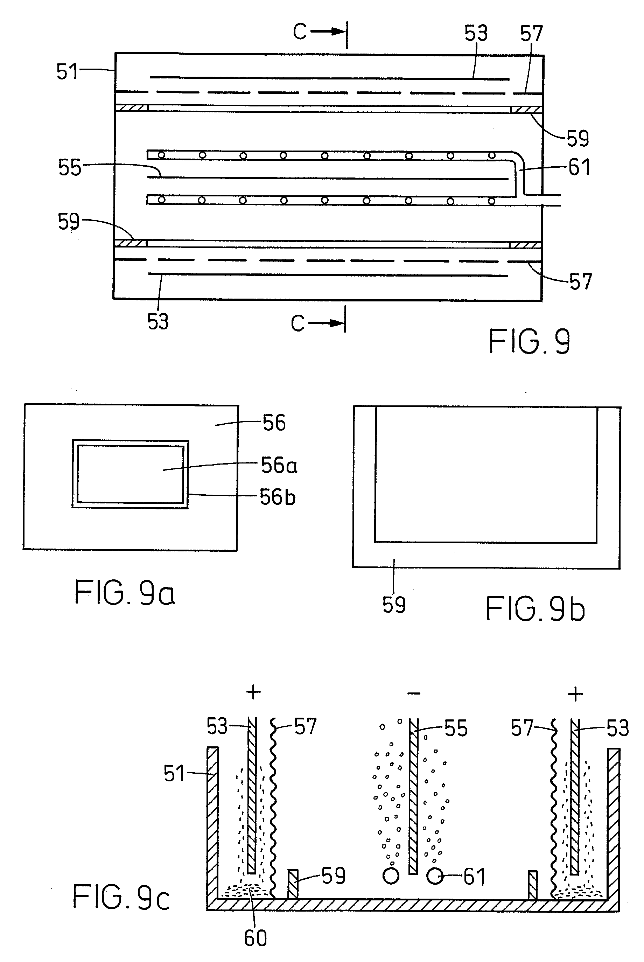

Das Galvanisieren oder Elektroplattieren mit Kupfer gemäss dem hier beschriebenen Ausführungsbeispiel der Erfindung kann in einer Vorrichtung gemäss den **Figuren 9 und 9c** durchgeführt werden. An dieser Stelle wird ein Batch-Prozess beschrieben, wo eine Probe in eine Elektrolytzelle eingebracht, bearbeitet und anschliessend aus der Zelle entfernt wird. Die Figur 9 schematisiert die Draufsicht auf eine Vorrichtung zum Galvanisieren in einer Vertikalanordnung. Die Figur 9c zeigt einen Schnitt entlang der Linie C-C der Figur 9. Die Vorrichtung weist einen Behälter 51 auf, in welchem peripher zwei Anodenstangen 53 und zentral eine Kathodenstange 55 angebracht sind. Die Kathodenstange dient zur Halterung und Kontaktierung einer in der **Figur 9a** in Frontansicht und in verkleinertem Massstab dargestellten Stahlplatte 56 mit einer Öffnung 56a. Die Öffnung 56a ist mit einer Spannvorrichtung 56b versehen, welche der Halterung des beschichteten Substrats dient. Weiter sind ein Diaphragma 57 und eine Blende 59 vorgesehen. Das Diaphragma 57 dient dazu, dass kein Anodenschlamm 60 in den die Kathode umgebenden Elektrolyten gerät. Die Blende dient der lateral begrenzten Abschirmung von Strömungen oder von elektrischen Feldern (siehe **Figur 9b**). Weiter sind als perforierte dielektrische Röhren ausgebildete Mittel 61 vorgesehen, durch welche die für jeden sauren Kupferelektrolyten notwendige Lufteinblasung erfolgt. Zusätzlich sind noch nicht gezeichnete Pump- und Filtermittel vorhanden, durch welche der Elektrolyt abgeführt, gefiltert und wieder dem Behälter zugeführt wird. Die durch diese Mittel bewirkte Elektrolytumwälzung beträgt bspw. 3 bis 5 Mal das Elektrolytvolumen pro Stunde.

Wesentlich dafür, dass im galvanischen Verfahrensschritt auch Vertiefungen "Lunker"-frei aufgefüllt werden, welche ein wie vorstehend erläutert relativ grosses Aspektverhältnis haben, ist die Zusammensetzung des Elektrolyten.

Es wurde nun überraschend gefunden, dass Verfahren der konventionellen Galvanotechnik für dekorative Zwecke - mit entsprechenden Anpassungen - zu diesem Zweck verwendet werden können. Solche Verfahren wurden bisher nicht für die Verwendung in der Leiterplattentechnik (bzw. zur Anwendung für elektrische Verbindungselemente generell) in Betracht gezogen. Sie sind bisher ausschliesslich dazu verwendet wurden, Oberflächen Glanz zu verleihen (dekorativ). Für das Aufwachsen von Material auf Oberflächen mit Vertiefungen, generell von strukturierten Oberflächen oder ganz allgemein für die funktionelle Galvanotechnik wurden sie bisher nicht verwendet.

Der Elektrolyt besitzt gemäss einer ersten Ausführungsform folgende Komponenten:
Schwefelsäure (H₂SO₄): 10-200 g/L
Kupfersulfat (CuSO₄x 5 H₂O): 50-500 g/L
Natriumchlorid (NaCl): 10-250 mg/L, sowie die organischen Zusätze
HSO C-WL Grundglanz der Firma HSO in Solingen, Deutschland: 0,5-5 mL/L
HSO C-WL Glanzträger: 0,5-5 mL/L
HSO C-WL Glanzzusatz 0,05-2 mL/L

Besonders vorteilhaft sind die Ergebnisse mit folgenden Parametern:

Schwefelsäure 45-70 g/L, Kupfersulfat 200-230 g/L, Natriumchlorid 100-190 mg/L, HSO C-WL Grundglanz 2,2-4,2 mL/L, HSO C-WL Glanzträger 1,6-2,8 mL/L, HSO C-WL Glanzzusatz 0,15-0,9 mL/L.

Optimale Resultate ergeben sich mit 45-60g/L Schwefelsäure, 210-230 g/L Kupfersulfat, 140-170 mg/L Natriumchlorid, 2,6-3,8 mL/L HSO C-WL Grundglanz, 1,7-2,5 mL/L HSO C-WL Glanzträger und 0,2-0,6 mL/L HSO C-WL Glanzzusatz.

Gemäss einer zweiten Ausführungsform werden für die anorganischen Komponenten dieselben Zusammensetzungen verwendet wie für die erste Ausführungsform:
Schwefelsäure (H₂SO₄): 10-200 g/L, vorzugsweise 45-70 g/L und bspw. 45-60 g/L
Kupfersulfat (CuSO₄ x 5 H₂O): 50-500 g/L, vorzugsweise 200-230 g/L und bspw. 210-230 g/L
Natriumchlorid (NaCl): 10-250 mg/L, vorzugsweise 100-190 mg/L und bspw. 140-170 mg/L.
Die organischen Komponenten werden aber im (konventionell galvanotechnischen) HSO C-OF-Verfahren der Fa. Schmidt in Solingen (DE) bereitgestellt.

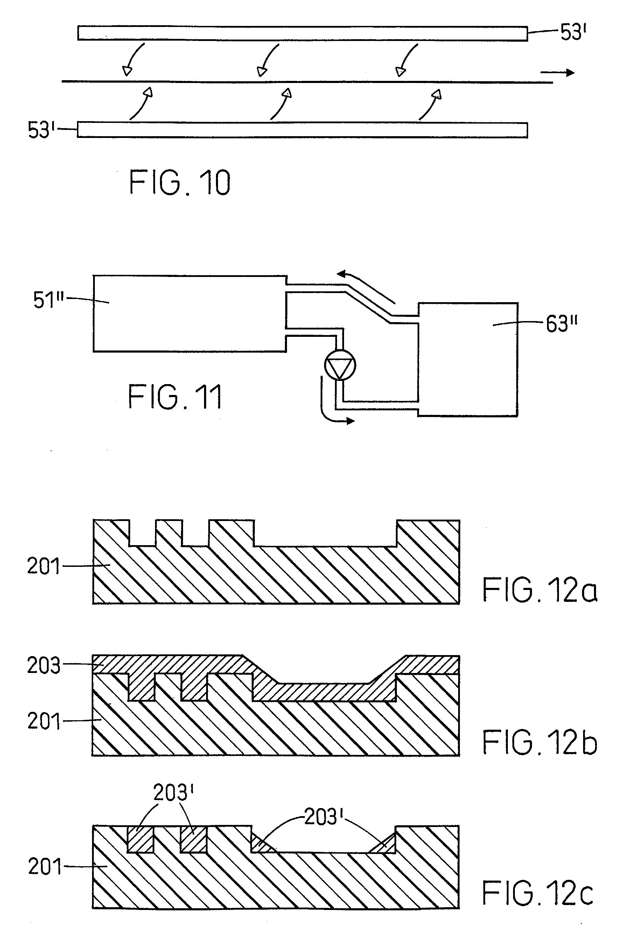

In der **Figur 10** ist noch eine Vorrichtung zur Durchführung des Ausführungsbeispiels des erfindungsgemässen Verfahrens als kontinuierlicher Prozess dargestellt. Ganz schematisch gezeigt ist eine Horizontalanordnung. Es sind aber auch, insbesondere in grossen Anlagen, kompliziertere Anordnungen mit Umlenkrollen etc. denkbar. In dieser Ausführungsform als kontinuierlicher Prozess ist keine Halterung des beschichteten Substrats nötig. Das als Kathode fungierende Substrat 1 (mit Beschichtung) ist bspw. wie vorstehend beschrieben als biegbare Folie ausgebildet und wird durch Rollen gespannt. Es wird bspw. während des ganzen Prozesses bewegt und in horizontaler Richtung durch den Elektrolytbehälter gezogen. Die Anoden 53' sind oberhalb und unterhalb oder beidseitig des Substrates angebracht. Die Vorrichtung weist Lufteinströmmittel und je nach dem ebenfalls Diaphragmen und Blenden auf, welche hier nicht noch einmal beschrieben werden sollen. Zusätzlich sind nicht gezeichnete Düsen zur ständigen Erzeugung einer Elektrolytströmung vorgesehen. Durch diese Strömung - in der Figur durch Pfeile symbolisiert - wird verhindert, dass der Elektrolyt mit der Zeit in der Nähe der Kathode lokal verarmt.

Ein Schema einer Variante zur Ausführung des erfindungsgemässen Verfahrens ist in der **Figur 11** aufgezeigt. In dieser Variante erfolgt der Kupferabscheidungsprozess auf dem beschichteten Substrat in einer Elektrolysezelle 51", welche von einem Behälter 63" getrennt ist, in welchem Kupfer vom festen Zustand in den Elektrolyt in Lösung gebracht wird. Es erfolgt dabei eine ständige Umwälzung von Elektrolyt, wobei verarmter Elektrolyt von der Elektrolysezelle 51" in den Behälter 63" und mit Kupfer angereicherter Elektrolyt vom Behälter in die Elektrolysezelle transportiert wird.

Das erfindungsgemässe Verfahren ist insbesondere zur Herstellung feiner Strukturen mit hohem Aspektverhältnissen > 1:2 geeignet, da die Tiefe der Kanäle auch durch die Dicke des verwendeten Dielektrikums begrenzt wird. Da die Dicke im Bereich von 10 - 200 Mikrometer liegt, haben die Leiterkanäle üblicherweise Breiten zwischen 10 und maximal 100 Mikrometer. In Leiterplattenanwendungen sind somit speziell feinste Leiterzüge sehr einfach und ökonomisch herzustellen. In praktisch allen Anwendungen sind jedoch auch grössere mit Metall belegte Flächen notwendig. So sind z.B. die Anschlussflächen für die auf die Leiterplatte zu lötenden Komponenten meist relativ gross und auch die Stromversorgungsleiter (Vcc und GND) müssen oftmals flächig ausgeführt werden. Diese Flächen würden nach dem Galvanisieren eine zu geringe Kupferschichtdicke aufweisen und nach dem Abdünnen des Kupfers würde in diesen flächigen Bereichen das Kupfer weggeätzt werden. Die **Figuren 12a, 12b und 12 c** zeigen dies schematisch auf. Dabei zeigt die Figur 12 a ein Substrat 201 nach dem Prägeschritt. In der Figur 12b ist dasselbe Substrat dargestellt, wobei es nach dem Beschichtungs- und dem Elektroplattierschritt mit einer Kupferschicht 203 versehen ist. Nach dem Zurückätzen bleibt gemäss Figur 12c nur in der Nähe von Stufen sowie in den Vertiefungen Kupfer 203' zurück.

Um diese grossflächigen Strukturen mit dem erfindungsgemässen Verfahren herstellen zu können, kann man verschiedene konstruktive Massnahmen treffen:

Die als Kontaktfläche auszubildende Fläche ist in feine Strukturen aufgerastert. Dies kann z.B. durch parallel verlaufende oder sich kreuzende feine Kanäle mit einem für das erfindungsgemässen Verfahren optimalen Aspektverhältnis bewerkstelligt werden. In einem solchen Falle können sehr gut Stromversorgungsebenen oder auch Schirmebenen hergestellt werden, da diese auch in konventionellen Anwendungen meist aufgerastert ausgeführt werden. Sollen jedoch Anschlussflächen zum Löten hergestellt werden, so würden die gerasterten Flächen keine gute Lötqualität erlauben und es muss das Verfahren so abgewandelt werden, dass geschlossene Lötflächen gebildet werden können.

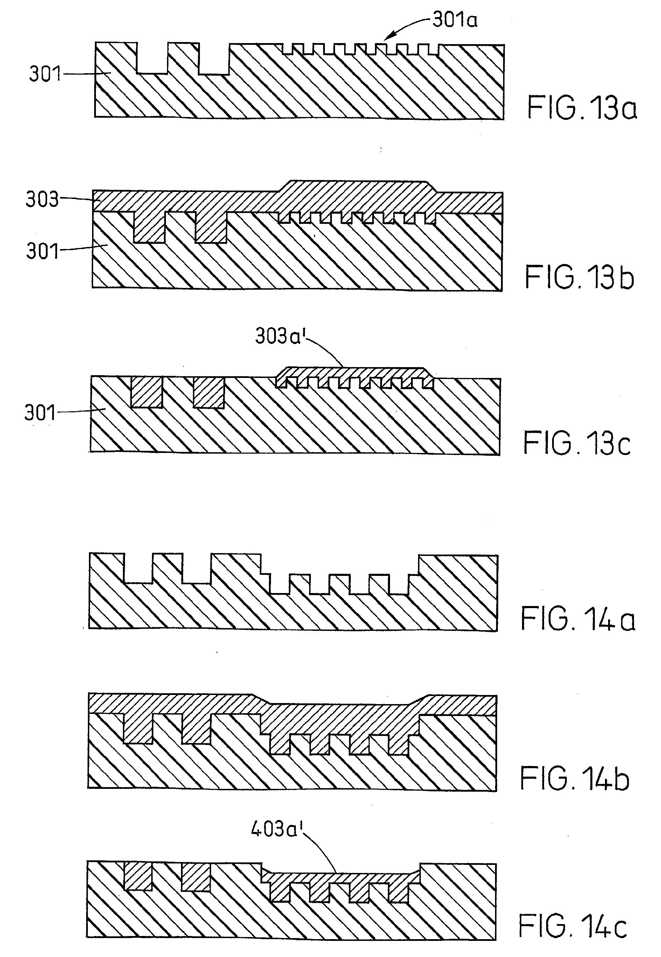

Eine Möglichkeit ist in den **Figuren 13a, 13b und 13c** dargestellt, wo analog zu den Figuren 12a bis 12c ein elektrisches Verbindungselement nach dem Prägeschritt, nach dem Elektroplattierschritt bzw. nach dem Zurückätzen dargestellt ist. Sie besteht darin, die flächigen Bereiche mit sehr feinen, dem Substrat 301 während des Prägeschritts beigebrachten Strukturen 301a aufzurastern. Diese Strukturen weisen Vertiefungen und dazwischen liegende Erhebungen auf. Die Tiefe dieser Strukturen, d.h. der Vertiefungen liegt bspw. unter T/2, wenn T die Tiefe der kanalförmigen Vertiefungen für Leiterbahnen darstellt. Dies führt zu einer künstlichen Verdickung des Kupfers in diesen Feinstrasterzonen und nach dem Abdünnen des Kupfers verbleibt eine geschlossene Restschicht 303a'. Die Rasterung kann in vielfältigster Weise erfolgen, z.B. parallele Leiterzüge, sich kreuzende Leiterzüge etc.

Dies Effekt kann auch erreicht werden, indem man ein Prägewerkzeug herstellt, dass neben den feinen Strukturen mit Vertiefungen und dazwischen liegenden Erhebungen auch grössere, flächige Strukturen beinhaltet. Ein entsprechendes elektrisches Verbindungselement ist in den **Figuren 14a, 14b und 14c** während verschiedenen Stadien der Herstellung dargestellt. Beim Aufgalvanisieren werden die feinen Strukturen schnell aufgefüllt und anschliessend werden die flächenhaften Strukturen aufgalvanisiert. Dies ergibt in der Summe eine leicht dickere Kupferschicht in diesen flächigen Bereichen und nach dem Abdünnen des Kupfers verbleibt eine geschlossene Restschicht 403a', d.h. die auch Erhebungen sind nach dem Rückätzschritt noch mit Kupfer bedeckt.

Das Aufrastern der flächigen Bereiche für Lötflächen hat auch den Vorteil, dass die Kupferschicht auf dem Dielektrikum mechanisch fest verankert wird, wodurch die Haftfestigkeit der Lötflächen stark erhöht werden kann.

Die Ausführungsbeispiele, anhand denen die Erfindung vorstehend erläutert wurde, beschränken sich auf die Herstellung von Leiterplatten. Bei Kenntnis der Erfindung wird der Fachmann ohne Weiteres erkennen, dass die Erfindung ebensogut zur Herstellung anderer elektrischer Verbindungselemente geeignet ist.

Weiter wurde bei der vorstehenden Beschreibung der Einfachheit halber davon ausgegangen, dass das Produkt des Verfahrens ein fertiges Verbindungselement ist. Der Fachmann wird natürlich ohne Weiteres Erkennen, dass zusätzlich zu den vorstehend beschriebenen Schritten auch noch weitere Bearbeitungsschritte zur Fertigstellung eines elektrischen Verbindungselementes unternommen werden können. Weiter ist das Verfahren auch für die Herstellung von Halbzeugen zur Weiterverarbeitung zu einem Verbindungselement geeignet. Ein solches Halbzeug kann bspw. mit anderen Bauteilen zu einem mehrlagigen elektrischen Verbindungselement verarbeitet werden.

Mit dem erfindungsgemässen Verfahren herstellbare elektrische Verbindungselemente können eine Vielzahl von möglichen Ausprägungen haben und sind generell in Gebieten verwendbar, in denen elektrische Verbindungselemente zum Einsatz kommen. Nebst herkömmlichen Verwendungen, bei denen die Leiterplatte mit miteinander elektrisch gekoppelten Elementen bestückt wird, eignet sich ein erfindungsgemässes Verbindungselement natürlich in hervorragender Weise für Anwendungen, bei der die Miniaturisierung weit fortgeschritten ist. Weiter sei auch auf Verwendungen verwiesen bei denen die Strombelastbarkeit der Leiterbahnen wesentlich ist. Solche Verwendungen werden dadurch begünstigt, dass wie vorstehend beschrieben, ein erfindungsgemässes Verbindungselement Bahnen mit einem speziell günstigen Querschnitt aufweisen können. So zeigt sich bspw., dass erfindungsgemässe Verbindungselemente als Planarspulen fungieren können, wobei bei einer entsprechend flexiblen Ausgestaltung des Materials durch Faltung der Spulen aufeinander mehrlagige Planarspulen gebildet werden können.

## Patentansprüche

1. Elektrisches Verbindungselement oder Halbzeug,
aufweisend ein Substrat (101) aus einem Polymermaterial
mit mechanisch beigebrachten kanalartigen Vertiefungen,
wobei die kanalartigen Vertiefungen beidseits im Substrat (101) vorhanden sind,
und wobei mindestens einige der kanalartigen Vertiefungen einen zu einer Oberfläche der isolierenden Schicht senkrechten Querschnitt aufweisen, in welchem das Aspektverhältnis mindestens 1:2 beträgt,
und im Wesentlichen vollständig mit galvanisch aufgetragenem, als Leiterbahnen verwendbarem Leitermaterial (103') aufgefüllt sind,
und mit mechanisch durch Prägen beigebrachten Durchgangslöchern.

2. Elektrisches Verbindungselement oder Halbzeug nach Anspruch 1, **dadurch gekennzeichnet, dass** das Aspektverhältnis ungefähr 1:1 oder mehr beträgt.

3. Elektrisches Verbindungselement oder Halbzeug nach Anspruch 1 oder 2, **gekennzeichnet durch** mindestens einen Bereich mit einer leitenden Kontaktfläche, welche von einer galvanisch mit Leitermaterial aufgefüllten Kanalstruktur besteht, wobei die Kanalstruktur als eine Reihe von voneinander **durch** Erhebungen getrennte Vertiefungen ausgebildet ist und wobei die Erhebungen mit dem galvanisch aufgebrachten Leitermaterial bedeckt sind.

4. Elektrisches Verbindungselement oder Halbzeug nach einem der Ansprüche 1 bis 3, **gekennzeichnet durch** in einem Prägeschritt und einem Nachreinigungsschritt beigebrachte Durchgangslöcher.

5. Elektrisches Verbindungselement nach einem der Ansprüche 1 bis 4, **dadurch gekennzeichnet, dass** die kanalartigen Vertiefungen eine Breite von zwischen 10 µm und 100 µm aufweisen.

6. Elektrisches Verbindungselement nach einem der Ansprüche 1 bis 5, **dadurch gekennzeichnet, dass** das Substrat als Folie ausgebildet ist.

7. Prägestempel zum Prägen eines plastisch verformbaren dielektrischen Substrates als Schritt im Herstellungsverfahren eines elektrischen Verbindungselementes oder Halbzeuges nach einem der Ansprüche 1 bis 6, **gekennzeichnet durch** kammförmige Erhebungen (11b) zum Beibringen von kanalförmigen Vertiefungen am Substrat, welche kammförmigen Erhebungen (11b) in einem Querschnitt senkrecht zur Oberfläche des Prägestempels eine Höhe (h') haben, die mindestens halb so gross ist wie eine Breite (b'), und **durch** zusätzliche dornartige Erhebungen (11c) zum Erzeugen von Durchgangslöchern im Zusammenspiel mit einem weiteren Prägestempel, wenn das dielektrische Substrat zwischen dem Prägestempel und dem weiteren Prägestempel zusammengepresst wird.

8. Vorrichtung (21) zum Prägen eines plastisch verformbaren dielektrischen Substrates als Schritt im Herstellungsverfahren eines elektrischen Verbindungselementes oder Halbzeuges nach einem der Ansprüche 1 bis 6, mit zwei Prägestempeln (11, 13), zwischen denen ein Substrat (101) zusammenpressbar ist, wobei die Prägestempel (11, 13) kammförmige Erhebungen (11b) zum Beibringen von kanalförmigen Vertiefungen am Substrat aufweisen, welche kammförmigen Erhebungen (11b) in einem Querschnitt senkrecht zur Oberfläche des Prägestempels eine Höhe (h') haben, die mindestens halb so gross ist wie eine Breite (b'), und wobei die Prägestempel zusätzlich dornartige Erhebungen (11c) zum Erzeugen von Durchgangslöchern aufweisen.

9. Vorrichtung nach Anspruch 8, **dadurch gekennzeichnet, dass** die genannten kammförmigen Erhebungen (11b) einen mindestens näherungsweise rechteckigen Querschnitt aufweisen.
